Europäisches Patentamt

European Patent Office

Office européen des brevets

(11) Publication number: **0 397 426**
**A2**

# EUROPEAN PATENT APPLICATION

(21) Application number: **90304901.3**

(22) Date of filing: **04.05.90**

(51) Int. Cl.5: **H01L 21/60**

(30) Priority: **09.05.89 JP 115880/89**

(43) Date of publication of application:
**14.11.90 Bulletin 90/46**

(84) Designated Contracting States:
**DE FR GB**

(71) Applicant: **Citizen Watch Co. Ltd.**
**1-1, 2-chome, Nishi-Shinjuku**
**Shinjuku-ku Tokyo(JP)**

(72) Inventor: **Ohi, Masayuki**
**4-5-98 Nishihara-cho**
**Tanashi-shi Tokyo(JP)**

(74) Representative: **Lawrence, John Gordon et al**
**McNeight & Lawrence Regent House Heaton**
**Lane**
**Stockport, Cheshire SK4 1BS(GB)**

(54) IC packaging structure and packaging method.

(57) In an IC packaging structure, ball bonding is performed on patterns on a circuit substrate as first bonding, and ballless bonding is performed on pad electrodes on an IC chip as second bonding. An IC packaging method includes a first step of forming a gold ball electrode on each of pad electrodes of an IC chip, a second step of ball-bonding one end of a gold wire on each of patterns of a circuit substrate, and a third step of thermally compression-bonding the other end of the gold wire on a corresponding one of the gold ball electrodes formed on the pad electrodes.

EP 0 397 426 A2

# IC PACKAGING STRUCTURE AND PACKAGING METHOD

## BACKGROUND OF THE INVENTION

### FIELD OF THE INVENTION

The present invention relates to an IC packaging structure and an IC packaging method.

### DESCRIPTION OF THE PRIOR ART

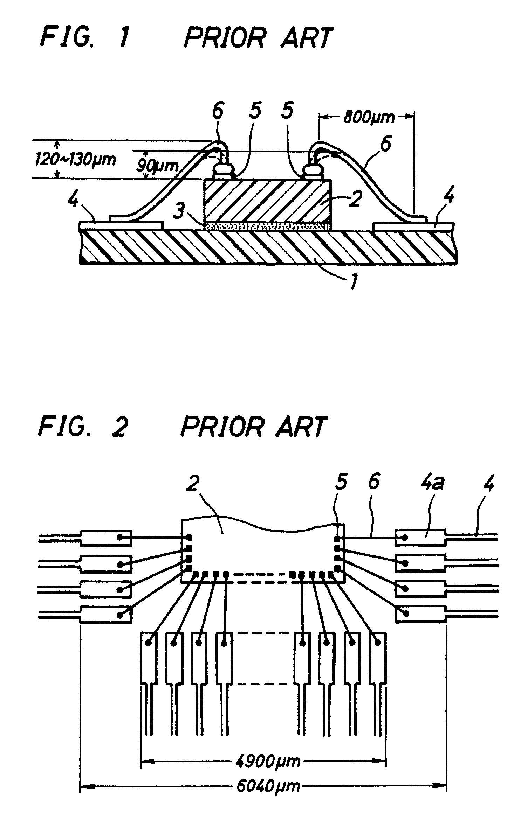

Fig. 1 is a sectional view showing a conventional IC packaging structure. Referring to Fig. 1, reference numeral 1 denotes a circuit substrate; 2, an IC chip having a memory, a logic circuit, or the like formed thereon; 3, an adhesive for fixing the IC chip 2 on the circuit substrate 1; 4, patterns formed on the circuit substrate 1; 5, pad electrodes formed on the IC chip 2; and 6, connection leads, consisting of gold wires or the like, for electrically connecting the pad electrodes 5 to the patterns 4.

In the conventional IC packaging structure having the above arrangement, ball bonding is performed on the pad electrodes 5 as first bonding, and stitch bonding is performed on the patterns 4 as second bonding, thereby electrically connecting the electrodes and the patterns.

Fig. 2 is a partial plan view showing a packaging structure in which the IC chip 2 shown in Fig. 1 is wire-bonded to the patterns 4. Sizes shown in Fig. 2 correspond to the IC chip 2 having 20 pad electrodes 5 on each side. That is, the size of a bonding portion 4a of each pattern 4 must be increased to perform stitch bonding. For this reason, the size of a pattern region on one side of the IC chip 2 becomes, e.g., 4,900 $\mu$m, and its packaging region for performing molding becomes about 6,040 $\mu$m

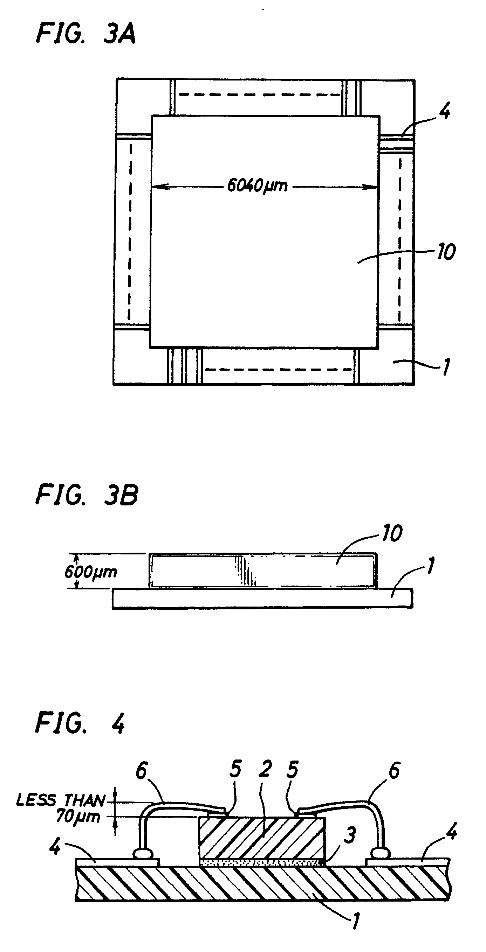

Figs. 3A and 3B show an IC packaging device obtained by resin-molding the packaging structure shown in Fig. 2, in which Fig. 3A is a plan view showing the molded IC packaging device and Fig. 3B is a side view showing the IC packaging device. As shown in Figs. 3A and 3B, a planar shape of a resin-encapsulated portion 10 formed on the circuit substrate 1 is a square having a 6,040-mm side and a thickness of 600 $\mu$m.

In the conventional IC packaging structure having the above arrangement, since the connection leads 6 rise substantially perpendicularly with respect to the surface of the IC chip 2 upon ball bonding as the first bonding, the loop height of each connection lead 6 from the upper surface of the IC chip 2 becomes as large as 120 to 130 $\mu$m.

Therefore, the thickness of the IC packaging device resin-encapsulating the above IC packaging structure cannot be decreased.

In addition, as shown in Fig. 1, after the connection leads 6 are ball-bonded to the IC chip 2, the leads 6 are pulled to be stitch-bonded on the patterns 4. If a position of stitch bonding is too close to the IC chip 2, the lead 6 is brought into contact with a corner of the IC chip 2 which forms a loop, i.e., so-called shoulder touch occurs. Therefore, since the connection lead 6 must be considerably loosely pulled to perform bonding, a distance between the pad electrodes 5 and the patterns 4 to be subjected to the second bonding must be set to be 800 $\mu$m or more. As a result, the outer diameter of the IC packaging device resin-encapsulating this IC packaging structure is increased.

In order to decrease the loop height of the connection lead 6, when stitch bonding is to be performed subsequently to ball bonding, the connection lead 6 may be strongly pulled to be connected as indicated by a broken line in Fig. 1. In this method, the loop height of the connection lead 6 can be decreased to be about 90 $\mu$m. Since, however, the connection lead 6 is bent through a sharp angle on an upper portion of a bond ball connected on the pad electrode 5, a breaking strength of the connection lead 6 is reduced. As a result, since a defect occurs due to a variation with time after packaging and encapsulating to degrade reliability. Therefore, a decrease in thickness of the packaging structure is limited.

## SUMMARY OF THE INVENTION

It is an object of the present invention to provide an IC packaging structure which has high reliability and can be made compact and thin and an IC packaging method therefor.

In order to achieve the above object, the gist of the present invention is as follows.

That is, the present invention is characterized by an IC packaging structure in which an IC chip is adhered on a circuit substrate and pad electrodes of the IC chip are wire-bonded to patterns on the circuit substrate, wherein ball bonding is performed on the patterns on the circuit substrate as first bonding, and ballless bonding is performed on the pad electrodes on the IC chip as second bonding.

The present invention is characterized by the above structure wherein ballless bonding as the second bonding is stitch bonding.

The present invention is characterized by an IC packaging method, wherein stitch bonding is performed with a bonder whose bonding capillary has a face angle $\theta$ at an end.

The present invention is characterized by the above method wherein the face angle $\theta$ of the bonding capillary is 2° to 15°.

The present invention is characterized by the above structure wherein ballless bonding as the second bonding is performed by thermally compression-bonding gold wires on ball electrodes formed on the pad electrodes of the IC chip.

The present invention is characterized by an IC packaging method in which an IC chip is adhered on a circuit substrate and pad electrodes on the IC chip are wire-bonded to patterns on the circuit substrate, comprising a first step of forming a gold ball electrode on each of the pad electrodes of the IC chip, a second step of ball-bonding one end of a gold wire on each of the patterns of the circuit substrate, and a third step of thermally compression-bonding the other end of the gold wire on a corresponding one of the gold ball electrodes formed on the pad electrodes.

BRIEF DESCRIPTION OF THE DRAWINGS

Fig. 1 is a sectional view showing a conventional IC packaging structure;

Fig. 2 is a partial plan view showing the IC packaging structure shown in Fig. 1;

Fig. 3A is a plan view showing a state in which the IC packaging structure shown in Fig. 1 is resin-molded, and

Fig. 3B is a side view showing the resin-molded packaging structure shown in Fig. 3A;

Fig. 4 is a sectional view showing a principle of an IC packaging structure according to the present invention;

Fig. 5 is a sectional view showing a main part of an embodiment of the IC packaging structure according to the present invention;

Fig. 6 is a partial plan view showing the IC packaging structure according to the present invention;

Fig. 7A is a plan view showing a state in which the IC packaging structure according to the present invention shown in Fig. 6 is resin-molded, and

Fig. 7B is a side view showing the same resin-molded IC packaging structure;

Fig. 8 is a sectional view showing a distal end shape of a conventional bonding capillary;

Fig. 9 is a sectional view showing a distal end portion of a bonding capillary used in the present invention;

Fig. 10 is a sectional view showing another embodiment of the IC packaging structure according to the present invention; and

Figs. 11A to 11D are sectional views showing steps of an IC packaging method according to the present invention.

DETAILED DESCRIPTION OF THE PREFERRED EMBODIMENTS

The present invention will be described in detail below with reference to the accompanying drawings.

Fig. 4 is a sectional view showing a principle of an IC packaging structure according to the present invention, in which the same reference numerals as in Fig. 1 denote the same parts and a detailed description thereof will be omitted. This structure differs from the conventional structure shown in Fig. 1 in that connection leads 6 are ball-bonded on patterns 4 as first bonding and then ballless-bonded on pad electrodes 5 as second bonding. In the present invention, "ballless bonding" means bonding performed without forming a ball at an end of a gold wire.

In this embodiment, an IC chip 2 is adhered on a circuit substrate 1. In place of the circuit substrate 1, however, a lead frame, a semiconductor substrate, or the like may be used.

As described above, according to the present invention, although ball bonding requiring a loop height is performed on the patterns on the circuit substrate, ballless bonding requiring almost no loop height is performed on the pad electrodes on the IC chip. Therefore, the loop height of the connection lead from the upper surface of the IC chip can be set to be 70 $\mu$m or less.

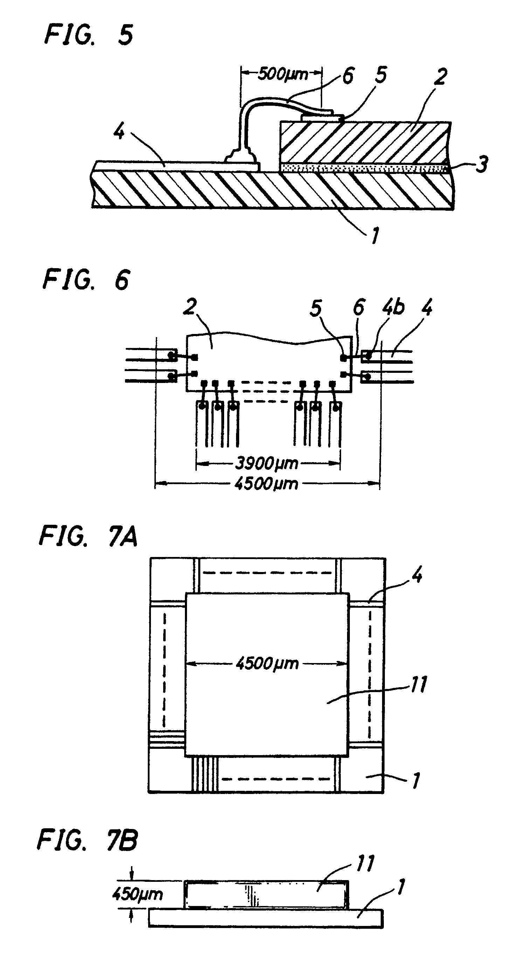

Fig. 5 is a sectional view showing a main part of an IC packaging structure according to the first embodiment of the present invention. In this embodiment, a connection lead 6 is ball-bonded on a pattern 4 as first bonding and then stitch-bonded on a pad electrode 5 on an IC chip 2 as second bonding. In a packaged state as shown in Fig. 5, the maximum loop height of the connection lead 6 from the pattern 4 is 400 $\mu$m even if variations are taken into consideration, and a distance between the first and second bonding positions is 500$\mu$m or less.

Fig. 6 is a partial plan view showing a packaging structure in which the IC chip 2 shown in Fig. 5 is wire-bonded to the pattern 4. Similar to Fig.2, sizes shown in Fig. 6 correspond to an IC chip having 20 pad electrodes 5 on each side. That is, a bonding portion 4b of each pattern 4 need only have a small area for performing ball bonding, the size of a pattern region of one side is 3,900 $\mu$m, and a packaging region for performing molding is 4,500 $\mu$m. That is, the pattern size of the present invention shown in Fig. 6 is smaller than the conventional pattern size shown in Fig. 2 by about 20%.

Figs. 7A and 7B show an IC packaging device obtained by resin-molding the packaging structure shown in Fig. 6, in which Fig. 7A is a plan view showing the res-in-modled IC packaging device and Fig. 7B is a side view thereof. As shown in Figs 7A and 7B, a planar shape of a resin-encapsulated portion 11 formed on the circuit sbstrate 1 is a square having a 4,500-μm side and a thickness of 450 μm. That is, the area and the thickness of the resin-encapsulated portion 11 of the present invention shown in Figs. 7A and 7B are smaller than those of the conventional resin-encapsulated portion 10 shown in Figs. 3A and 3B by about 55% and about 70%, respectively.

In addition, in order to perform good stitch bonding on the pad electrode 5, a bonding capillary most suitable for the surface state of the pad electrode 5 must be used.

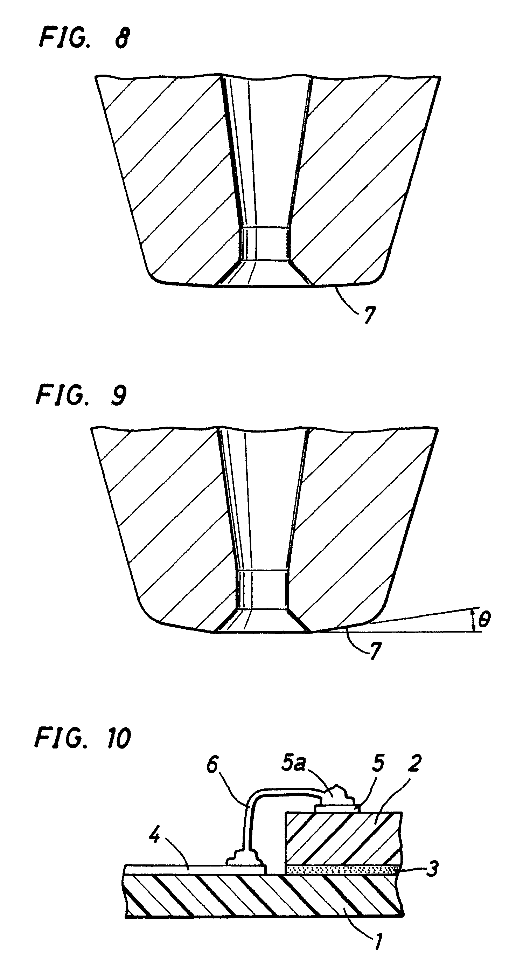

Fig. 8 is a sectional view showing a main part of a conventional bonding capillary having a flat distal end portion 7. When the bonding capillary having the flat distal end portion was used to perform stitch bonding on the surface of the pad electrode 5, stress concentration between the surface of the pad electrode 5 and the connection lead 6 became insufficient to degrade bonding properties and destroy a passivation film around the pad electrode.

Fig. 9 is a sectional view showing a main part of a distal end portion of a bonding capillary used to practice the present invention. This bonding capillary differs from the conventional structure shown in Fig. 8 in that a face angle $\theta$ is provided at end portion 7 of the bonding capillary. By the face angle $\theta$, stress concentration was obtained between the surface of the pad electrode 5 and the connection lead 6 to obtain satisfactory bonding characteristics.

In this case, when the pad electrode 5 was hard, good bonding characteristics were obtained by setting the face angle $\theta$ to be about 2° outwardly. When the pad electrode 5 was soft, good bonding characteristics were obtained when the face angle $\theta$ was set to be a maximum of 15° outwardly.

Fig. 10 is a sectional view showing a main part of an IC packaging structure according to the second embodiment of the present invention. In this embodiment, a gold ball electrode 5a is formed beforehand on a pad electrode 5 of an IC chip 2, and a connection lead 6 having one end ball-bonded to a pattern 4 as first bonding is thermally compression-bonded at its other end to the gold ball electrode 5a formed on the pad electrode 5.

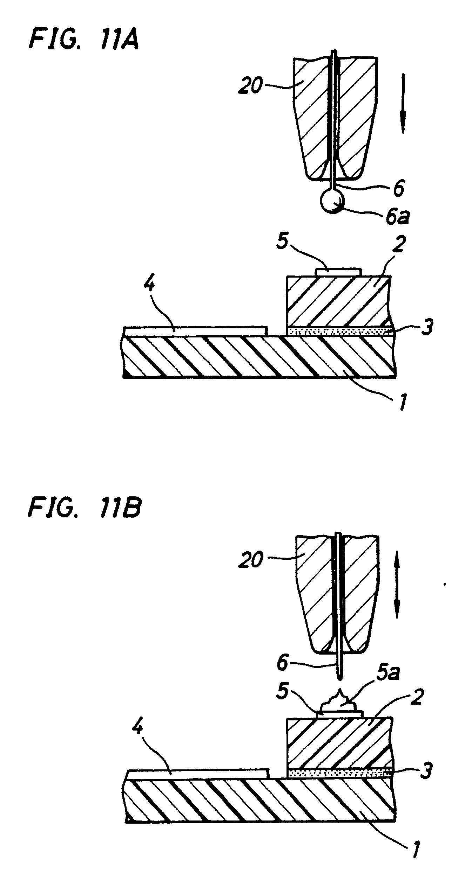

The connection method shown in Fig. 10 will be described in more detail below with reference to Figs. 11A to 11D.

Figs. 11A to 11D are sectional views showing steps of connecting the IC chip 2 and the pattern 4 according to the above embodiment. Fig. 11A shows a preliminary step in which a capillary 20 having a gold ball 6a formed at an end of a gold wire (to be referred to as a gold wire 6 hereinafter) to serve as the connection lead 6 is moved downward above the pad electrode 5 of the IC chip 2 as indicated by an arrow.

Fig. 11b shows the first step for forming a gold ball electrode, in which the capillary 20 is vertically moved as indicated by arrows on the pad electrode 5 to be subjected to second bonding, thereby performing ball bonding. Thereafter, the gold wire 6 is cut to form the gold ball electrode 5a.

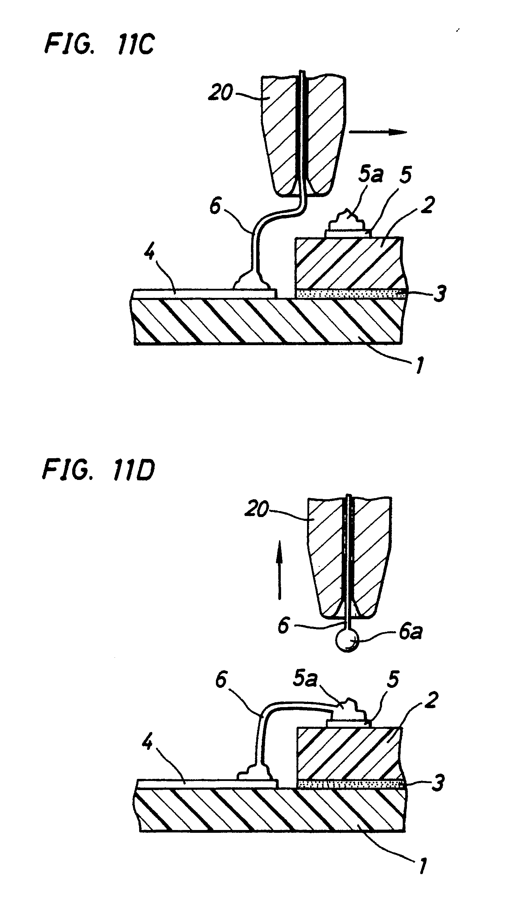

Fig. 11C shows the second step for performing first bonding, in which one end of the gold wire 6 at which the gold ball 6a is reformed is ball-bonded to the pattern 4. Thereafter, the capillary 20 is moved to a position above the pad electrode 5 as indicated by an arrow.

Fig. 11D shows the third step for performing second bonding, in which the other end of the gold wire 6 is bonded by thermal compression bonding to the gold ball electrode 5a formed on the pad electrode 5.

By the above four steps, wire bonding between the the pad electrode 5 of the IC chip 2 and the pattern 4 is completed. When the capillary 20 having the gold ball 6a reformed at the distal end of the gold wire 6 is moved upward as indicated by an arrow shown in Fig. 11D and moved to a position above the next pad electrode 5 as shown in Fig. 11A, wire bonding of the next pad electrode and the pattern is started. The above four steps are repeatedly performed to connect a required number of pad electrodes and patterns.

In the third step shown in Fig. 11D, the other end of the gold wire 6 is connected to the gold ball electrode 5a formed on the pad electrode 5 by thermal compression bonding at a temperature of 150°C with a load of 50 g and no US (ultrasolic) power.

Figs. 11A to 11D show the method of performing wire bonding between the pad electrode and the pattern by sequentially switching the bonding conditions of the four steps. The method of the present invention, however, is not limited to the above method but may be a method in which gold ball electrodes 5a are formed beforehand on all of pad electrodes 5 and the second and third steps shown in Figs. 11C and 11D are repeated to perform wire bonding between the pad electrodes 5 and patterns 4. Alternatively, the gold ball electrode 5a on the pad electrode 5 may be formed by a method other than ball bonding.

As is apparent from the above description, according to the present invention, while ball bonding requiring a loop height is performed on a circuit substrate, ballless bonding requiring almost no loop height is performed on a pad electrode on an IC chip. Therefore, the loop height of a connection lead from the upper surface of the IC chip can be set to be smaller than that of the conventional structure.

In addition, since the pattern on the circuit substrate need only have an area required for ball bonding, the size of the pattern is much smaller than that of a conventional wide pattern for stitch bonding, and a distance between first and second bonding positions can be reduced. As a result, a resin-encapsulated IC packaging device can be made much smaller and thinner than a conventional device.

Furthermore, since a reduction in breaking strength of a connection lead caused upon low loop bonding which is a conventional problem does not occur in the present invention, a packaging structure having high reliability in which no defect is produced due to a variation with time after packaging and encapsulating can be obtained. Since the present invention can be practiced by only changing the shape of a distal end portion of a bonding capillary or changing some of wire bonding steps, a packaging cost is not increased. Therefore, the present invention can effectively decrease the thickness and improve reliability of a packaging structure.

The expression balless bonding used herein means a bonding with no ball formed at an end off the gold wire.

## Claims

1. An IC packaging structure in which an IC chip is adhered on a circuit substrate and pad electrodes on said IC chip are wire-bonded to patterns on said circuit substrate, characterized in that ball bonding is performed on said patterns on said circuit substrate as first bonding, and ballless bonding is performed on said pad electrodes on said IC chip as second bonding.

2. The structure according to claim 1, wherein ballless bonding as the second bonding is stitch bonding.

3. An IC packaging method, characterized in that stitch bonding is performed with a bonder whose bonding capillary has face angle $\theta$ at an end thereof.

4. The method according to claim 3, wherein the face angle $\theta$ of said bonding capillary is $2°$ to $15°$.

5. The structure according to claim 1, wherein ballless bonding as the second bonding is performed by thermally compression-bonding gold wires on ball electrodes formed on said pad electrodes of said IC chip.

6. An IC packaging method in which an IC chip is adhered on a circuit substrate and pad electrodes on said IC chip are wire-bonded to patterns on said circuit substrate, comprising:
a first step of forming a gold ball electrode on each of said pad electrodes of said IC chip;
a second step of ball-bonding one end of a gold wire on each of said patterns of said circuit substrate; and
a third step of thermally compression-bonding the other end of said gold wire on a corresponding one of said gold ball electrodes formed on said pad electrodes.

## FIG. 1    PRIOR ART

## FIG. 2    PRIOR ART

FIG. 3A

6040μm
4
10
1

FIG. 3B

600μm
10
1

FIG. 4

6 5 2 5 6
LESS THAN
70μm
4 3 4
1

FIG. 5

FIG. 6

FIG. 7A

FIG. 7B

FIG. 8

FIG. 9

$\theta$

7

FIG. 10

6    5a    5    2

4

3

1

FIG. 11A

FIG. 11B

FIG. 11C

FIG. 11D